# DEMANDE DE BREVET EUROPEEN

(11) **EP 3 926 078 A1**
(43) Date de publication de la demande: **22.12.2021**
(21) Numéro de dépôt: 21179412.8
(22) Date de dépôt: 15.06.2021
(51) Int. Cl.: C30B 15/14, C30B 29/06, C30B 29/08, C30B 11/14, C30B 15/10, C30B 17/00

(54) **PROCÉDÉ DE FABRICATION D'UN CRISTAL SEMI-CONDUCTEUR**

(30) Priorité: 15.06.2020 FR 2006197
(71) Demandeur: Commissariat à l'Energie Atomique et aux Energies Alternatives, 75015 Paris (FR)
(72) Inventeur: PIHAN, Etienne, 38054 GRENOBLE CEDEX 09 (FR); NEHARI, Abdeldjelil, 38054 GRENOBLE CEDEX 09 (FR)
(74) Mandataire: Nony

(57) **Abrégé**

Procédé de fabrication d'une pièce par solidification d'un matériau semi-conducteur Procédé de fabrication d'une pièce (70) comportant un col (40) et un fût (60) prolongeant le col, la pièce comportant une portion monocristalline représentant plus de 80 % de son volume, le procédé comportant les étapes de :
i) fourniture d'un creuset (5) contenant un bain (20) comportant un matériau semi-conducteur en fusion choisi parmi le silicium, le germanium et leurs mélanges, et d'un germe (25) solide comportant le matériau semi-cristallin,
ii) mise en contact du germe avec le bain,
iii) formation du col en translatant le germe par rapport au bain pour extraire et solidifier le matériau semi-conducteur hors du bain, et
iv) formation du fût en refroidissant le bain et en réduisant la vitesse de translation du germe par rapport à l'étape iii),
la pièce présentant au moins une section, transverse à l'axe (X) de translation du germe, dont l'aire est supérieure ou égale à 0,15 m².

## Description

L'invention concerne la solidification de pièces en un matériau semi-conducteur monocristallin, notamment destinées à des applications photovoltaïques.

Des procédés sont connus pour produire des lingots de silicium pour des applications photovoltaïques.

Le procédé le plus largement mis en œuvre est le procédé de solidification Czochralski, généralement dénommé procédé « Cz », par exemple décrit dans US 2,768,914 A. Un tel procédé permet de fabriquer des lingots de silicium d'une hauteur généralement de l'ordre de 1 m, et pouvant atteindre 2 m. Cependant, le diamètre des lingots est généralement de l'ordre de 200 mm et il est difficile, voire impossible, d'atteindre des diamètres supérieurs à 400 mm, à cause du gradient thermique vertical imposé de forte intensité et du poids trop élevé de tels lingots. Par exemple, un lingot d'un diamètre de 400 mm pour application dans le domaine de la microélectronique a été décrit dans Y. Shiraishi et al., Journal of Crystal Growth 229, (2001) 17-2. Cependant, sa fabrication est particulièrement complexe et coûteuse. En outre, en fin de solidification, il est nécessaire de former un cône final allongé pour éviter la formation de dislocations. Ce cône final, qui peut représenter plus de 10 % du volume du lingot Cz, ne peut être utilisé pour des applications photovoltaïques. Enfin, le procédé Cz présente un rendement qui diminue avec l'augmentation du diamètre du lingot.

Un autre procédé bien connu est le procédé de solidification « Mono-Like » ou « ML-Si », par exemple décrit dans US 2012/042947 A1. Il consiste à former un pavage de germes monocristallins au fond d'un creuset, à fondre une charge de silicium disposée sur le pavage pour former un bain, puis à solidifier le bain pour obtenir un lingot ayant des portions de même orientation que les germes dont elles sont issues. La technique de solidification « Mono-Like » présente une productivité élevée et produit des lingots de bonne qualité cristalline.

La croissance du lingot est obtenue en imposant un profil thermique spécifique au bain de silicium contenu dans le creuset, de telle sorte que la croissance s'initie au contact des germes et progresse sensiblement de bas vers le haut en conservant l'orientation cristallographique du germe. Cependant, la maîtrise du profil thermique est primordiale au cours de la solidification dirigée. A défaut, des cristaux d'orientations différentes de celles des germes se développent au cours de la solidification. Les plaquettes découpées dans le lingot présentent alors des défauts qui réduisent le rendement énergétique des cellules photovoltaïques dans lesquelles elles sont intégrées.

En outre, de nombreuses dislocations sont générées lors de la fusion initiale des germes puis de la cristallisation du lingot ML-Si. Elles proviennent notamment des efforts entre les germes. Or, les germes sont des plaquettes de silicium découpées dans un lingot obtenu par le procédé de solidification Cz. Ils présentent donc une longueur et/ou une largeur limitée à 300 mm au plus.

Un autre procédé de fabrication dénommé « NeoGrowth », décrit par exemple dans US 2016/230307 A1, consiste à solidifier une partie d'une couche de croissance comportant du silicium en fusion sur un germe, pour former un lingot, tout en alimentant la couche de croissance en silicium en fusion pour maintenir la couche de croissance à l'état liquide sur le germe et en déplaçant le lingot en formation pour amener une nouvelle partie de la couche de croissance à solidifier. La couche de croissance forme une nappe maintenue sur le lingot en formation sous l'effet de la tension de surface du silicium liquide sur le silicium solide. Elle n'est pas contenue par les parois latérales d'un creuset. Le diamètre de la couche de croissance est donc limité par le diamètre du germe. Tout comme pour la méthode ML-Si, le germe est découpé dans un lingot Cz. Les lingots obtenus par le procédé NeoGrowth ont un diamètre, mesuré transversalement à l'axe de croissance du lingot, qui n'excède donc pas 300 mm.

Un procédé connu pour fabriquer des lingots de plus grand diamètre que les procédés présentés ci-dessus est le procédé Kyropoulos, par exemple décrit dans "A method of making large crystals", Kyropoulos, S., Journal of Inorganic and General Chemistry, 154 (1), 308-313, 1926, doi: 10.1002 / zaac.19261540129. Il consiste à mettre en contact un germe monocristallin au contact d'un bain de silicium en fusion, puis à refroidir progressivement le bain. Le lingot obtenu peut présenter un diamètre pouvant atteindre 90 % du diamètre du creuset. Le procédé Kyropoulos permet de fabriquer des lingots d'un diamètre supérieur à 500 mm. Cependant, les surfaces isothermes au cours de la solidification au moyen de ce procédé sont incurvées, souvent sphériques, ce qui génère une importante densité de dislocations, et l'interface de solidification présente de nombreuses faces cristallines d'orientation différente. Un autre inconvénient du procédé Kyropoulos est la faible maîtrise de la forme du lingot.

Un objectif de la présente invention consiste donc à fournir un nouveau procédé de fabrication permettant de surmonter les inconvénients précités.

A cet effet, l'invention propose un procédé de fabrication d'une pièce comportant un col et un fût prolongeant le col, la pièce comportant une portion monocristalline représentant plus de 80 % de son volume, le procédé comportant les étapes de :
i) fourniture d'un creuset contenant un bain comportant un matériau semi-conducteur en fusion choisi parmi le silicium, le germanium et leurs mélanges, et d'un germe solide comportant le matériau semi-cristallin,
ii) mise en contact du germe avec le bain,
iii) formation du col en translatant le germe par rapport au bain pour extraire et solidifier le matériau semi-conducteur hors du bain, et
iv) formation du fût en refroidissant le bain et en réduisant la vitesse de translation du germe par rapport à l'étape iii),
la pièce présentant au moins une section, transverse à l'axe de translation du germe, dont l'aire est supérieure ou égale à 0,15 m².

L'invention permet de fabriquer une pièce présentant une excellente qualité cristalline avec un rendement élevé, en limitant le développement de zones de forte densité de dislocations. La formation préalable du col permet de limiter le développement initial de dislocations dans la pièce en formation, puis les conditions de formation du fût permettent d'empêcher la solidification du bain contre le creuset.

L'invention permet en outre de fabriquer une pièce dont au moins une partie majoritaire est monocristalline et qui peut en plus être de grand diamètre.

La pièce peut présenter un diamètre supérieur ou égal à 500 mm, voire supérieur ou égal à 750 mm, voire supérieur ou égal à 1 m.

La pièce peut présenter au moins une section, transverse à l'axe de translation du germe, dont l'aire est supérieure ou égale à 0,2 m², de préférence supérieure ou égale à 0,5 m², de préférence supérieure ou égale à 0,7 m², par exemple d'environ 1,0 m².

En particulier, la pièce peut présenter une portion monocristalline représentant plus de 90 %, voire plus de 95 %, voire plus de 99 % du volume de la pièce. La pièce peut être entièrement monocristalline.

Le fût peut comporter une portion monocristalline représentant plus de 90 %, voire plus de 95 %, voire plus de 99 % du volume de la pièce. Le fût peut être monocristallin.

Le fût peut présenter un diamètre supérieur ou égal à 500 mm, voir supérieur ou égal à 750 mm, voire supérieur ou égal à 1 m.

De plus, le procédé permet de maitriser la forme de la pièce, et notamment la forme du fût. Le fût peut présenter une forme générale prismatique ou de pyramide tronquée. Il peut présenter une épaisseur comprise entre 15 mm et 50 mm.

Comme cela apparaîtra clairement par la suite, la pièce peut ainsi présenter des dimensions et une qualité cristalline qui la rendent adaptée à être utilisée pour initier la croissance d'un lingot, par exemple par solidification dirigée ou par croissance NeoGrowth.

### Etape i) - creuset, bain et germe

Le bain peut comporter pour plus de 80,0 % de sa masse, voire pour plus de 90,0 %, voire pour plus de 99,9 % de sa masse, le matériau semi-conducteur.

De préférence, le bain contient pour moins de 0,01 % de sa masse des impuretés. La pièce est ainsi adaptée aux applications photovoltaïques. Les « impuretés » sont des constituants inévitables, introduits involontairement et nécessairement avec les matières premières ou résultant de réactions avec ces constituants pour former le bain. Les impuretés ne sont pas des constituants nécessaires, mais seulement tolérés. Par exemple, les impuretés peuvent contenir du fer.

De préférence, le matériau semi-conducteur est le silicium.

De préférence, l'épaisseur du bain est inférieure ou égale à 10 cm, de préférence inférieure ou égale à 5 cm. Ainsi, un faible gradient thermique entre la surface et le fond de du bain peut être aisément établi.

De préférence, l'aire de la surface du bain est supérieure à 0,15 m², de préférence supérieure à 0,5 m², voire supérieure à 0,8 m², par exemple de 1,0 m².

Le creuset peut comporter une paroi de fond et des parois latérales qui s'étendent à partir de la paroi de fond selon l'axe de translation du germe.

Le diamètre de la paroi de fond peut être supérieur, par exemple au moins deux fois supérieur, à la hauteur des parois latérales.

Le creuset peut être en graphite. Les parois de fond et latérale peuvent être recouvertes d'un revêtement antiadhérent, par exemple en nitrure de silicium.

Le creuset peut être un creuset de solidification dirigée de type « Mono-Like ». Le bain et le germe peuvent être de compositions identiques.

Le germe peut présenter une forme générale prismatique, notamment parallélépipèdique ou cylindrique de révolution.

Le germe peut présenter un diamètre compris entre 10 mm et 15 mm.

Par « diamètre » d'un germe, d'une portion de la pièce ou de la pièce, on entend le diamètre du plus petit cercle circonscrit autour de la section du germe, de la portion de la pièce ou de la pièce respectivement qui est transverse à l'axe de translation du germe et qui est d'aire la plus étendue.

Le germe est de préférence monocristallin. Il peut présenter une orientation (100) ou (110) parallèle à l'axe de translation du germe.

### Etape ii) - Mise en contact du germe

De préférence, au moins durant l'étape ii) et notamment au cours des étapes ii) à iv), le procédé comporte le chauffage du bain de telle sorte que le gradient de température entre la surface du bain et le fond du bain, mesuré selon la direction de translation du germe, est inférieur à 3 K/cm. Un tel faible gradient thermique favorise la formation d'une pièce de grand diamètre tout en limitant l'apparition et le développement de défauts cristallins, en empêchant la génération d'un champ de contraintes de forte intensité. Le gradient thermique entre la surface du bain et la fond du bain peut être plus élevé au cours de l'étape iii) de formation du col qu'au cours de l'étape iv) de formation du fût.

De préférence, au moins durant l'étape ii) et notamment au cours des étapes ii) à iv) la température du bain est comprise entre T_{f} + 5 K et T_{f} + 10 K, T_{f} étant la température de fusion du matériau semi-conducteur. A titre illustratif, la température de fusion du silicium est égale à 1687 K.

Le germe peut être mis au contact du bain en translatant le germe selon un axe de translation perpendiculaire à la surface du bain.

De préférence, l'axe de translation du germe est vertical.

De préférence, la mise en contact du germe avec le bain comporte en outre la rotation du germe par rapport au bain, la rotation étant opérée autour de l'axe de translation du germe. Ainsi, le flux de matériau semi-conducteur en fusion en contact du germe est homogénéisé et stabilisé, ce qui améliore la qualité cristalline du col formé à l'étape iii).

La rotation du germe à l'étape ii) est effectuée de préférence autour d'un axe perpendiculaire à la surface du bain, de préférence autour de l'axe de translation du germe.

La vitesse de rotation du germe à l'étape ii) est de préférence comprise entre 10 rpm et 15 rpm [révolutions par minute].

La rotation à l'étape ii) peut être effectuée alternativement, notamment périodiquement, entre deux positions angulaires extrêmes dans un sens puis dans un sens opposé.

De préférence, afin de produire une pièce présentant une forme sensiblement symétrique et présentant une répartition de défauts cristallin la plus homogène possible, le germe est mis en contact au centre de la surface du bain.

### Etape iii) - Formation du col

De préférence, le col est monocristallin.

Le diamètre du col est de préférence inférieur au diamètre du germe.

Le diamètre du col est inférieur au diamètre du fût.

De préférence, la formation du col comporte la solidification d'une striction, en translatant le germe à une vitesse de translation et à une température du bain déterminées pour que le diamètre de la striction soit inférieur à 10 mm, voire inférieur ou égal à 6 mm, de préférence compris entre 4 mm et 5 mm. Un tel faible diamètre permet d'éliminer les dislocations en provenance du germe et se propageant et/ou se multipliant dans la pièce en formation.

De préférence, la vitesse de translation du germe lors de la formation de la striction est supérieure ou égale à 30 mm/h, de préférence supérieure ou égale à 60 mm/h et de préférence inférieure ou égale à 200 mm/h, de préférence inférieure ou égale à 90 mm/h.

Le germe peut être translaté de la surface du bain à l'étape iii) d'une distance comprise entre 10 mm et 100 mm. La striction peut ainsi présenter une longueur, mesurée selon l'axe de translation du germe, correspondant à ladite distance.

La température du bain à l'étape iii) peut être comprise entre T_{f} + 5 K et T_{f} + 10 K.

De préférence, la formation du col comporte la solidification d'un cône d'élargissement prolongeant la striction le long de l'axe de translation du germe, le cône d'élargissement étant formé par translation du germe à une vitesse inférieure à la vitesse mise en œuvre pour former la striction, le cône d'élargissement ayant un diamètre supérieur au diamètre de la striction.

La vitesse de déplacement du germe au cours de la formation du cône d'élargissement peut être comprise entre 20 mm/h et 90 mm/h, de préférence comprise entre 30 mm/h et 60 mm/h.

La solidification du col peut être poursuivie jusqu'à ce que l'aire de la face du cône d'élargissement en contact avec le bain soit comprise entre 10 % et 20 % de l'aire de la surface du bain. L'homme du métier sait déterminer les conditions pour obtenir un tel cône d'élargissement. En particulier, il sait que l'aire maximale atteignable de la section transverse du cône d'élargissement est limitée par la stabilité de l'interface entre le bain et le cône en formation.

Le cône d'élargissement présente de préférence une forme générale d'un cône de révolution dont la génératrice est l'axe de translation du germe.

De préférence, la formation du col comporte la rotation du germe autour de l'axe de translation du germe, en vue de produire un lingot homogène et présentant une symétrie autour dudit axe.

La vitesse de rotation du germe au cours de la formation du col peut être supérieure ou égale à 5 rpm et de préférence inférieure à 20 rpm. Elle peut être effectuée alternativement, notamment périodiquement, entre deux positions angulaires extrêmes d'abord dans un sens puis dans un sens opposé.

### Etape iv) - formation du fût

Lors de la formation du fût, le refroidissement du bain peut être opéré préalablement ou conjointement ou postérieurement à la réduction de la vitesse de translation.

Le refroidissement peut être effectué au moyen d'un extracteur de chaleur, par exemple une boîte à eau, disposé sous le bain. L'extracteur de chaleur peut notamment être au contact avec le creuset, notamment avec la paroi de fond du creuset le cas échéant.

En particulier, la vitesse de translation du germe au cours de l'étape iv) de formation du fût peut être inférieure ou égale à 10 mm/min.

A l'étape iv), de manière à obtenir un fût au diamètre élargi par rapport au col, le bain est refroidi de préférence de telle sorte que le gradient de température selon au moins une direction parallèle à la surface du bain, de préférence une direction horizontale, soit inférieur à 3 K/cm, de préférence inférieur à 2 K/cm. Le refroidissement peut être opéré en réduisant la puissance de chauffage des parois latérales du creuset et/ou en augmentant le flux de refroidissement de la paroi de fond du creuset.

La formation du fût peut comprendre :
- l'élargissement du fût par solidification d'une partie du bain le long de la surface du bain, suivi par
- la croissance axiale du fût le long de l'axe de translation du germe.

En particulier, l'élargissement du fût peut être opéré à une vitesse de translation du germe inférieure ou égale à 1 mm/min, voire nulle.

La formation du fût, notamment dans une première partie de l'élargissement du fût, peut comporter la rotation du germe à l'étape iv) autour de l'axe de translation du germe.

La vitesse de rotation du germe au cours de la formation du fût, notamment de la première partie de l'élargissement du fût, peut être supérieure à 5 rpm et de préférence inférieure à 10 rpm.

La rotation du germe peut être opérée jusqu'à ce que l'aire de la face du fût au contact du bain soit comprise entre 50 % et 70 %, par exemple 60 %, de l'aire de la surface du bain.

Par ailleurs, au cours d'une optionnelle deuxième partie de l'élargissement du fût, le germe peut être bloqué en rotation jusqu'à ce que l'aire de la face du fût au contact du bain soit d'au moins 80 % de l'aire de la surface du bain. Le fût peut être élargi jusqu'à ce qu'il présente un pourtour de forme sensiblement homothétique du contour intérieur d'une section transverse du creuset. Une telle deuxième phase est notamment mise en œuvre lorsque la pièce découpée est sous la forme d'une plaque destinée à la cristallisation d'un lingot par solidification dirigée, comme cela sera décrit par la suite.

La croissance axiale du fût peut être opérée à une vitesse de translation du germe supérieure à la vitesse de translation du germe au cours de l'élargissement du fût.

En particulier, la vitesse de translation du germe au cours de la croissance du fût peut être comprise entre 10 mm/h et 20 mm/h.

Le germe peut être translaté au cours de la croissance du fût sur une distance supérieure à 10 mm, voire supérieure à 15 mm, par exemple comprise entre 40 mm et 50 mm.

### Etapes optionnelles

Le procédé comporte de préférence, postérieurement à l'étape iv) de formation du fût, le décollement de la pièce du bain.

Préalablement au décollement, un chauffage du bain est opéré, de préférence à une température comprise entre T_{f} + 10 K et T_{f} + 15 K. Le chauffage permet de déstabiliser l'interface de solidification entre le bain et le fût, afin de faciliter le décollement.

Le décollement peut être opéré par translation du germe le long de l'axe de translation.

Le germe peut être immobile en rotation au cours du décollement.

De préférence, afin d'assurer un décollement optimal de la pièce sans rupture de cette dernière, la vitesse de translation du germe au cours du décollement est supérieure à 5400 mm/h.

En variante, la vitesse de translation du germe peut être réduite et la paroi de fond du creuset peut être chauffée de telle sorte que l'augmentation résultante de la température du bain induise une rupture du ménisque formé entre la pièce et le bain. Le décollement de la pièce est ainsi assuré. Par ailleurs, postérieurement au décollement de la pièce, le procédé comporte de préférence le refroidissement de la pièce.

Au moins l'intégralité du fût, de préférence de la pièce, est disposée dans le creuset au cours du refroidissement. La pièce refroidissant ainsi à proximité du creuset, les chocs thermiques au cours du refroidissement sont évités, limitant ainsi la multiplication de défauts cristallins.

Selon un premier mode de mise en œuvre du refroidissement, la pièce peut être refroidie jusqu'à une température comprise entre T_{f} - 150K et T_{f} - 100 K. Elle peut ensuite être maintenue à une telle température. En variante, la pièce peut être refroidie jusqu'à une température supérieure ou égale à T_{f} - 100 K. En particulier, un tel refroidissement peut résulter du décollement par translation de la pièce par rapport au bain, aucun contact entre le bain et la pièce n'étant assuré entre la pièce et le bain.

De préférence, le procédé peut en outre comporter la solidification d'une base par refroidissement du bain, notamment jusqu'à ce que la température de la base soit comprise entre T_{f} - 50 K et T_{f} - 40 K. La solidification de la base peut être effectuée conjointement au refroidissement de la pièce. En particulier, elle peut résulter du décollement par translation de la pièce par rapport au bain.

Selon un deuxième mode de mise en œuvre du refroidissement, la pièce peut être refroidie jusqu'à une température inférieure à 450 °C, de préférence inférieure à 200 °C, de préférence comprise entre 15 °C et 45 °C. La pièce peut ensuite être extraite du creuset, le cas échéant, et stockée.

Par ailleurs, le procédé peut comporter, postérieurement à l'étape de refroidissement notamment mise en œuvre selon le deuxième mode de mise en œuvre décrit ci-dessus, la découpe du fût pour former une plaque, et optionnellement l'usinage de la plaque sous une forme générale prismatique, de préférence de forme d'un pavé droit.

La pièce peut être découpée transversalement à la direction de translation du germe.

La plaque peut présenter une longueur et/ou une largeur supérieure à 300 mm, voire supérieures ou égales à 350 mm, voire supérieures ou égales à 400 mm, voire supérieures ou égales à 500 mm, voire supérieures ou égales à 750 mm, voire d'environ 1 m.

La plaque peut présenter un diamètre supérieur ou égal à 500 mm, voire supérieur ou égal à 750 mm, voire d'environ 1 m.

### Solidification d'un lingot à partir de la pièce

Le procédé peut comporter la mise en place de la plaque au fond d'un creuset et la solidification dirigée, dans le creuset, d'un lingot par initiation de la croissance cristalline sur la plaque.

De préférence, la pièce est découpée de telle sorte que la plaque recouvre plus de 90%, plus de 95% de l'aire du fond du creuset. Avantageusement, le lingot ainsi obtenu est exempt des défauts rencontrés dans les lingots classiquement obtenus par solidification dirigée par croissance cristalline au contact d'un pavage de germes, qui présentent généralement des défauts cristallins initiés et s'étant propagés à partir des interfaces entre les germes adjacents.

En variante, le procédé peut comporter, la fabrication d'un lingot par solidification de couches surfaciques à partir de la pièce, ou le cas échéant de la plaque. En particulier, un pavage tel que décrit dans la demande WO 2014/191899 A1, incorporé par référence, peut être réalisé au moyen de la plaque ou de la pièce, qui définit ainsi le joint central du pavage, contigu à au moins un joint périphérique.

Une méthode de fabrication d'un lingot par solidification de couches surfaciques, communément dénommée méthode « NeoGrowth », est par exemple décrite dans US 2016/230307 A1, incorporé par référence.

De préférence, la fabrication du lingot par solidification de couches surfaciques est réalisée postérieurement à l'étape de refroidissement mise en œuvre selon le premier mode de mise en œuvre décrit ci-dessus. On évite ainsi la formation de défauts au cours de la solidification du lingot, qui se formeraient lors d'un refroidissement de la pièce à basse température, par exemple à l'ambiante, puis chauffage pour mettre en œuvre la solidification du lingot.

De préférence, la fabrication du lingot par solidification de couches surfaciques comporte la mise en contact préalable du fût avec la base. Par exemple, la base peut être déplacée par rapport à la pièce qui est immobile dans un référentiel terrestre. La fabrication du lingot est simplifiée, puisqu'effectuée avec le même creuset, que celui ayant servi à la production de la pièce.

La fabrication du lingot par solidification de couches surfaciques peut comporter la suppression, de préférence par fusion, du col de manière à conserver le fût.

De préférence, la fabrication du lingot par solidification de couches surfaciques comporte :
a) la fourniture d'une couche de croissance sur la face de la pièce opposée à la base, ou le cas échéant, sur une face de la plaque, la couche de croissance étant formée d'une charge liquide comportant, de préférence pour plus de 80,0 %, de préférence pour plus de 90%, de préférence pour plus de 99,9 % de sa masse le matériau semi-conducteur en fusion,
b) la génération d'un champ de température définissant une zone de solidification dans laquelle la température est inférieure à la température de fusion du matériau semi-conducteur, et
c) le déplacement de la base pour disposer une portion de la couche de croissance dans la zone de solidification pour former le lingot et l'alimentation de la couche de croissance hors de la zone de solidification en charge liquide,
la couche de croissance étant alimentée de préférence continûment en charge liquide conjointement au déplacement de la base.

Ainsi, initialement lorsqu'une portion de la couche de croissance est disposée dans la zone de solidification, le matériau semi-conducteur qu'il contient est solidifié. En déplaçant la base de manière à amener dans la zone de solidification une partie de la couche de croissance rechargée en matériau semi-conducteur, il est ainsi possible de former une nouvelle portion de matériau semi-conducteur solidifié.

La couche de croissance peut être alimentée au moyen de gouttes de charge liquide tombant par gravité sur la couche de croissance. En particulier, la charge liquide peut être disposée dans un creuset secondaire, par exemple en quartz, disposé au-dessus de la couche de croissance et qui comporte un fond percé d'au moins un trou capillaire, de manière à ce que des gouttes de charge liquide se forment par écoulement gravitaire à travers le trou capillaire.

L'épaisseur de la couche de croissance peut être inférieure à 7 mm.

La couche de croissance peut être formée par fusion d'une couche surfacique du fût qui est opposée à la base.

De préférence, la fabrication du lingot est effectuée dans le même creuset que celui dans lequel la pièce a été produite. En variante, la fabrication du lingot peut être effectué dans un four multizone, dans autre creuset différent que celui mis en œuvre pour former la pièce.

La couche de croissance peut être distante des parois latérales du creuset.

Dans une variante, la couche de croissance est au contact des parois latérales du creuset. En particulier, la hauteur de la couche de croissance peut alors être supérieure à 7 mm. Le lingot est alors formé au contact des parois latérales. De préférence, pour faciliter le démoulage, les parois latérales du creuset sont pourvues d'un revêtement anti-adhérant, pour faciliter le démoulage du lingot.

L'invention concerne encore une pièce obtenue par le procédé selon l'invention.

Par ailleurs, elle concerne, selon un autre de ses aspects, une pièce formée pour plus de 99,9 % de sa masse par un matériau semi-conducteur choisi parmi le silicium, le germanium et leurs mélanges, la pièce comportant une portion monocristalline représentant plus de 80 % du volume de la pièce, la pièce présentant au moins une section transverse à un axe de la pièce dont l'aire est supérieure ou égale à 0,15 m², de préférence supérieure ou égale à 0,2 m², de préférence supérieure ou égale à 0,5 m², de préférence supérieure ou égale à 0,7 m², par exemple d'environ 1,0 m².

La pièce peut présenter un diamètre supérieur à 300 mm, voire supérieur ou égal à 350 mm, voire supérieur ou égal à 400 mm, voire supérieur ou égal à 500 mm, voire supérieur ou égal à 750 mm, voire d'environ 1 m. Elle peut présenter une épaisseur supérieure ou égale à 1 cm.

La pièce peut comporter un col et un fût prolongeant le col selon l'axe. La pièce peut être obtenue par le procédé selon l'invention. Elle peut comporter une ou plusieurs de caractéristiques de la pièce obtenue par le procédé selon l'invention.

La pièce peut se présenter sous la forme d'une plaque. La plaque est de préférence obtenue par le procédé selon l'invention, comportant l'étape de découpe de la pièce.

La plaque peut présenter au moins un, de préférence deux, côtés d'une de ses grandes faces de longueur supérieure à 300 mm, voire supérieure à 350 mm, voir supérieure à 400 mm, voire supérieure à 500 mm, voire supérieure à 750 mm, voire supérieure à 1 m.

La plaque peut présenter une épaisseur comprise entre 15 mm et 50 mm.

L'invention concerne enfin l'utilisation d'une pièce selon l'invention, en particulier sous la forme d'une plaque, pour la solidification, notamment dirigée, d'un lingot de silicium par croissance cristalline initiée sur la pièce.

### Figures

L'invention pourra être mieux comprise à la lecture de la description détaillée qui va suivre et des exemples et au moyen du dessin annexé dans lequel :
[Fig. 1a] la figure la est une vue de face d'une coupe verticale d'un ensemble comportant un creuset contenant un bain liquide, un germe et une pièce, au cours d'un exemple de mise en œuvre d'une étape du procédé selon l'invention,
[Fig. 1b] la figure 1b est un agrandissement de la zone G encadrée sur la figure la,
[Fig. 1c] la figure 1c est une vue de dessus d'une coupe horizontale, selon un plan parallèle à la surface du bain liquide contenu dans le creuset, de l'ensemble illustré sur la figure la,
[Fig. 2a] la figure 2a est une vue de face d'une coupe verticale de l'ensemble illustré sur la figure la, selon une autre étape de l'exemple de mise en œuvre du procédé,
[Fig. 2b] la figure 2b est une vue en coupe horizontale telle que selon la figure lc, de l'étape du procédé illustrée sur la figure 2a,
[Fig. 3] la figure 3 est une vue de face d'une coupe verticale de l'ensemble illustré sur la figure la, selon encore une autre étape de l'exemple de mise en œuvre du procédé,
[Fig. 4] la figure 4 est une vue en perspective d'une plaque,
[Fig. 5] la figure 5 est une vue de face d'une coupe verticale de l'ensemble illustré sur la figure la, selon encore une autre étape de l'exemple de mise en œuvre du procédé,
[Fig. 6] la figure 6 est une vue de face d'une coupe verticale de l'ensemble illustré sur la figure la, selon encore une autre étape de l'exemple de mise en œuvre du procédé,
[Fig. 7] la figure 7 est une vue de face d'une coupe verticale de l'ensemble illustré sur la figure la, selon encore une autre étape de l'exemple de mise en œuvre du procédé,
[Fig. 8] la figure 8 est une vue de face d'une coupe verticale de l'ensemble illustré sur la figure la, selon encore une autre étape de l'exemple de mise en œuvre du procédé,
[Fig. 9a] est une photographie en vue de dessus d'une pièce obtenue selon un exemple de mise en œuvre du procédé, et
[Fig. 9b] est une photographie en vue de face de la pièce illustrée sur la figure 9a.

Par souci de clarté du dessin, les proportions des différents éléments illustrés ne sont pas représentées à l'échelle.

### Description détaillée

Comme cela est illustré sur la figure la, le procédé selon l'invention peut être mis en œuvre au moyen d'un creuset 5, pour fabriquer une pièce selon l'invention.

Le creuset comporte une paroi de fond 10 et des parois latérales 15 qui s'étendent à partir de la paroi de fond parallèlement à un axe Y de symétrie du creuset, qui est vertical.

Un bain 20, se présentant sous la forme d'un bain, est contenue entre la paroi de fond et les parois latérales. Le creuset peut comporter des congés reliant chacun la paroi de fond 10 à l'une des parois latérales 15. La paroi de fond 10 peut présenter une face ayant une forme conique ou une forme d'une pyramide inversée.
le bain est par exemple formé, à l'exclusion des impuretés, par du silicium en fusion. Sa température est initialement comprise entre 1419 °C et 1444 °C.

Un germe 25 monocristallin de silicium est disposé au-dessus du bain.

Le germe peut présenter une forme cylindrique de révolution et présenter une orientation (100) parallèle à l'axe du cylindre. Il peut être déplacé jusqu'à entrer en contact avec la surface 30 du bain, par un mouvement de translation selon un axe de translation X vertical, qui est de préférence confondu avec l'axe de symétrie du creuset. Il est en outre de préférence animé d'un mouvement de rotation R, alternant entre deux positions angulaires extrémales, autour de l'axe X de translation à une vitesse de rotation comprise entre 5 et 20 rpm.

A proximité du bain, par capillarité, le silicium en fusion se déplace vers le haut, d'environ 5 à 8 mm lorsqu'il est en contact et tiré par le germe. Un ménisque 35 est ainsi formé sous l'effet des interactions mutuelles entre le germe, le bain, et l'atmosphère environnante. Le ménisque est ensuite maintenu tout au long de la formation de la pièce, jusqu'au décollement de cette dernière.

Le germe est ensuite translaté selon l'axe X vers le haut, afin de former un col 40, tel qu'illustré sur la figure la, qui comporte une striction 45 et un cône d'élargissement 50 prolongeant la striction le long de l'axe X.

Au cours de la formation du col, le bain est chauffé au moyen d'organes de chauffage 55 qui s'étendent le long des parois latérales et qui sont configurés pour induire un gradient de température vertical dans le creuset. Ainsi, lors d'un déplacement vertical du germe 25 pour éloigner ce dernier de la surface 30 du bain, la portion du bain au contact du bain est entraînée dans une zone du creuset où la température est inférieure à la température de fusion du matériau semi-conducteur, ce qui induit sa solidification.

Le germe 25 est d'abord translaté à une vitesse de translation qui peut être de l'ordre de 200 mm/h, de façon à former la striction 45, qui présente un diamètre φₛ inférieur au diamètre φ_{g} du germe. De préférence, le germe est animé d'un mouvement de rotation autour de l'axe X de translation durant la formation de la striction, par exemple dans les mêmes conditions qu'au cours de l'étape de mise en contact du germe avec le bain liquide. Les dislocations générées au contact du germe sont ainsi annihilées.

La vitesse de translation du germe est ensuite réduite, par exemple à une valeur comprise entre 30 et 60 mm/h, ce qui a pour effet de provoquer un élargissement progressif du col. Ainsi le cône d'élargissement 50 est formé, qui prolonge la striction selon l'axe X. La rotation R du germe autour de l'axe X peut être maintenue au cours de la formation du cône d'élargissement, de manière à former un cône de révolution dont la génératrice est l'axe X.

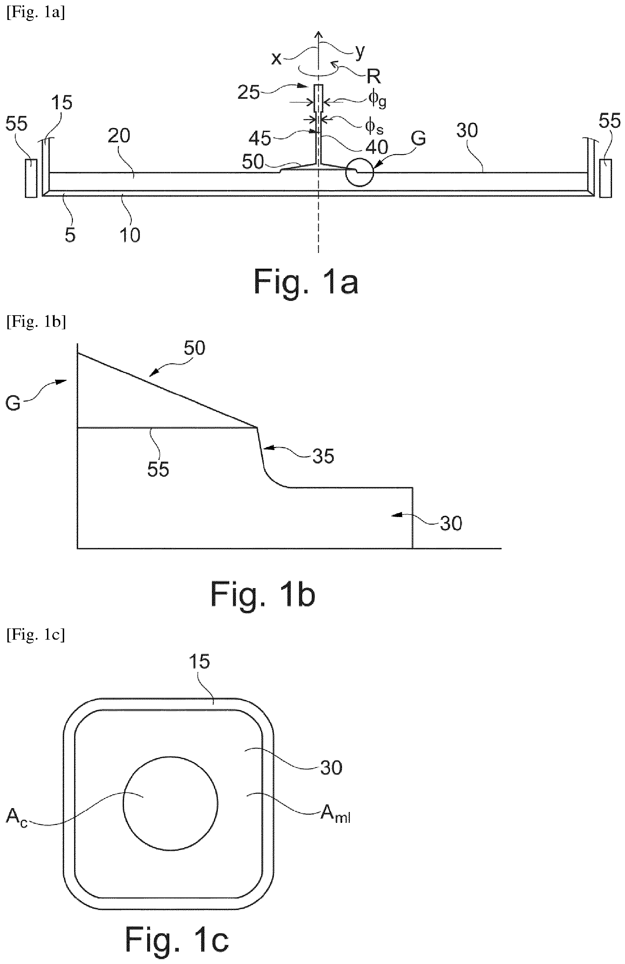

La formation du cône d'élargissement est poursuivie jusqu'à ce que l'aire A_{c} de la face 55 du cône d'élargissement en contact avec le bain atteigne entre 10 % et 20 % de l'aire Aₘₗ de la surface du bain, comme illustré sur la figure 1c. Par exemple, le bain couvre une surface dont l'aire est d'environ 1 m², et le cône d'élargissement peut présenter à sa base un rayon compris entre environ 0,18 m et 0,25 m.

Le fût 60 est ensuite formé en réduisant la vitesse de translation du germe et en refroidissant le bain, par exemple en réduisant la puissance de chauffe des organes de chauffe latéraux.

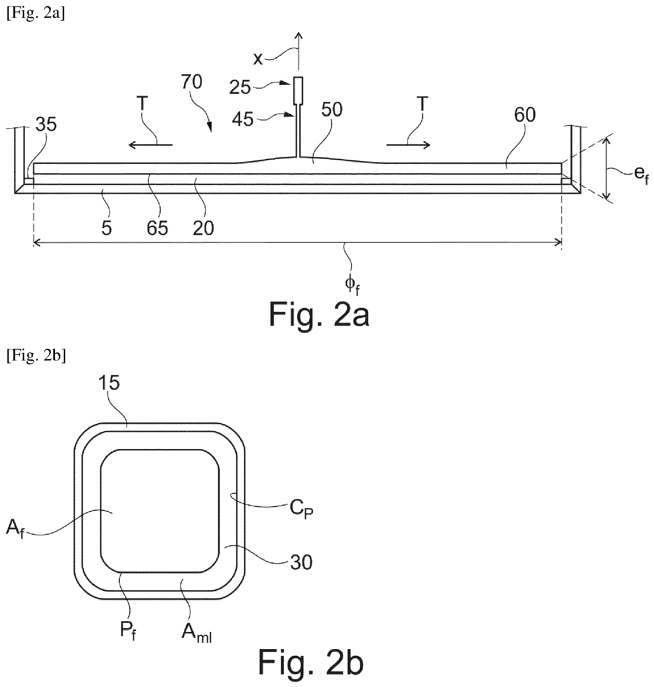

Un exemple de formation du fût est illustré sur la figure 2a.

La première portion du fût est formée en réduisant la vitesse de translation du germe à moins de 1 cm/h. De préférence, le germe est bloqué en translation. Sous l'effet du refroidissement du bain, le fût s'élargit transversalement à l'axe de translation, comme illustré par les flèches T, *i.e.* horizontalement, par solidification d'une portion du bain proche de la surface de cette dernière.

Une rotation du germe peut être opérée au cours d'une première partie de l'élargissement du fût, par exemple jusqu'à ce que l'aire de la face du fût au contact du bain représente au plus 60 % de l'aire de la surface du bain. Dans une deuxième partie de l'élargissement, le germe peut être bloqué en rotation, et notamment être immobile, de telle sorte que le fût s'étende auprès, par exemple jusqu'à moins de 30 mm, des parois 15 du creuset. Lorsqu'observé selon l'axe de translation du germe, comme illustré sur la figure 2b, la face 65 du fût en contact avec le bain peut présenter un pourtour P_{f} qui est de forme homothétique au contour intérieur Cₚ des parois du creuset.

L'élargissement du fût peut être opéré jusqu'à ce que l'aire A_{f} de la face du fût au contact du bain atteigne 80 % de l'aire Aₘₗ de la surface du bain.

Le germe est alors translaté à une vitesse par exemple comprise entre 1 cm/h et 2 cm/h de sorte à opérer la croissance du fût, pendant une durée adaptée à ce que l'épaisseur e_{f} du fût, mesurée selon l'axe de translation soit par exemple comprise entre 1,5 cm et 5 cm.

Dans le cas illustré, le fût ainsi obtenu présente une forme générale prismatique à base rectangulaire et est constitué pour plus de 80 %, préférentiellement au moins 90 % de son volume par une portion monocristalline.

Le fût peut par exemple présenter un diamètre φ_{f} qui peut être supérieur à 300 mm.

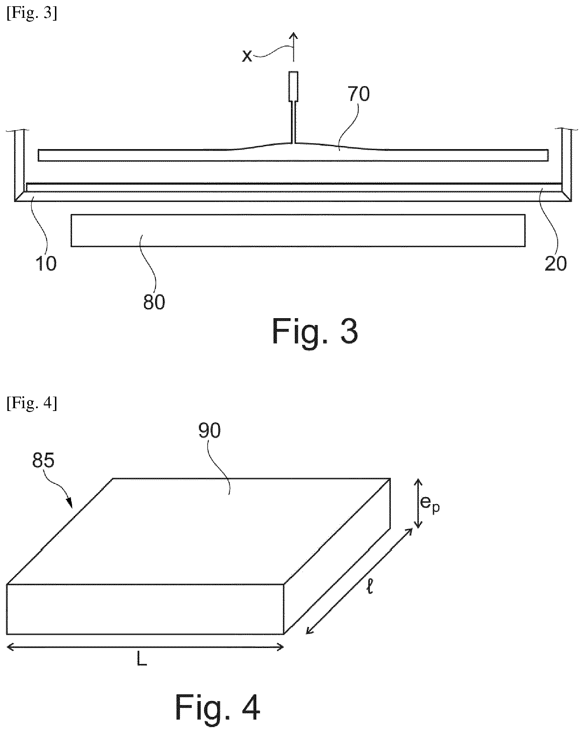

La pièce 70 est ensuite décollée du bain comme cela est illustré sur la figure 3. Pour faciliter le décollement, le bain peut être préalablement chauffé. Un flux de chaleur est par exemple transféré au bain à travers la paroi de fond au moyen d'un organe de chauffage 80 disposé sous le creuset.

La pièce est ensuite déplacée vers le haut à une vitesse de translation du germe élevée, par exemple d'environ 90 mm.min⁻¹.

En variante, la pièce peut être décollée en imposant un flux de chaleur sur la paroi de fond du creuset de manière à réchauffer le bain, et à provoquer la rupture du ménisque 35 par montée de l'interface liquide/solide dans le ménisque.

La pièce peut ensuite être extraite du creuset pour être refroidie hors de ce dernier. De préférence, au moins le fût 60 est maintenu dans le creuset, à distance du bain. Ainsi, suite à l'arrêt de la chauffe du creuset, le refroidissement de la pièce s'effectue progressivement conjointement au refroidissement du creuset, ce qui permet de limiter le développement de défauts cristallins.

La pièce peut être refroidie jusqu'à température ambiante, puis après extraction du creuset, peut être usinée de manière à former une plaque 85, telle que représentée sur la figure 4. En particulier, le fût peut être découpé selon des directions transversales à l'axe X.

La plaque ainsi obtenue, pouvant présenter une grande face 90 d'aire supérieure à 0,15 m², voire d'environ 1 m², et étant sensiblement monocristalline, peut avantageusement être destinée à recouvrir, notamment intégralement, la paroi de fond d'un creuset pour produire un lingot par solidification dirigée au contact de la plaque.

Elle peut présenter une longueur L et/ou une largeur 1 supérieures à 0,3 m, voire supérieures à 0,5 m. L'épaisseur de la plaque est par exemple comprise entre 2 cm et 3 cm.

Ainsi, un lingot monocristallin fabriqué par solidification dirigée d'une masse supérieure à 200 kg, voire supérieure à 500 kg, voire supérieure à 1000 kg peut être produit au moyen d'une plaque selon l'invention.

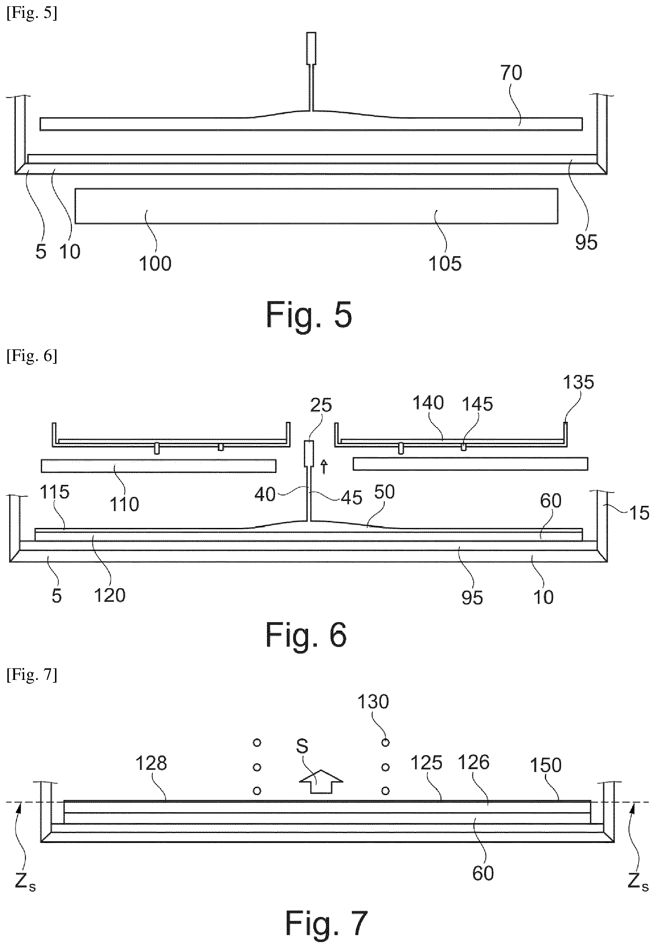

En variante, comme illustré sur la figure 5, après le décollement, le fût peut être maintenu dans le creuset et la pièce peut être refroidie jusqu'à ce que sa température soit comprise entre 1264 °C et 1314 °C. Par ailleurs, le bain peut être solidifié jusqu'à formation d'une base 95 au contact de la paroi de fond du creuset, par échange de chaleur à travers la paroi de fond de creuset au moyen d'une boite à eau 100, ou de tout autre extracteur 105 de chaleur adapté, disposé sous le creuset.

La pièce est ensuite déplacée verticalement vers le bas jusqu'à être disposée en contact avec la base, comme illustré sur la figure 6, la température de la base pouvant être supérieure à 1364 °C. Alternativement le creuset peut être déplacé vers le haut jusqu'au contact de la pièce avec la base.

Le col 40, et optionnellement le germe 25, sont ensuite fondus au moyen d'au moins un élément de chauffage supérieur 110 superposé verticalement au-dessus de la pièce. L'élément de chauffage supérieur induit en outre une fusion d'une portion supérieure 115 du fût, qui forme avec la matière issue de la fusion du col une couche de silicium en fusion à la surface de la portion infondue 120 du fût.

Une fabrication d'un lingot par solidification de couches surfaciques peut alors être mise en œuvre sur le fût monocristallin, qui définit alors un cristal de germination pour la formation du lingot. La couche de silicium en fusion est alors une couche de croissance 125 du lingot.

Le creuset est chauffé de façon à générer un champ de température qui définit une zone de solidification Zₛ dans laquelle la portion inférieure 126 de la couche de croissance est solidifiée au contact du fût, (délimitée par le trait discontinu horizontal sur la figure 7) la température y étant inférieure à la température de fusion du silicium, et hors de laquelle la portion supérieure complémentaire 128 de la couche de croissance est maintenue à l'état liquide. Le creuset est déplacé verticalement vers le bas, de manière à disposer une nouvelle portion de la couche de croissance dans la zone de solidification. La solidification s'effectue ainsi du bas vers le haut comme illustré par la flèche S.

Afin d'assurer le maintien de la couche de croissance à l'état liquide, la fabrication peut comporter l'alimentation de la couche de croissance par un écoulement gravitaire, notamment sous forme de gouttes 130 de silicium en fusion. Les gouttes sont produites par un creuset secondaire 135 disposé au-dessus du fût, qui contient une charge 140 de silicium en fusion, maintenue en température au moyen de l'élément de chauffage supérieur 110. Le creuset secondaire présente par ailleurs un fond percé de trous capillaires 145 pour la formation des gouttes.

De préférence, l'alimentation de la couche de croissance et le déplacement du creuset s'effectuent continûment au cours de la fabrication du lingot.

Dans la variante illustrée sur la figure 7, la couche de croissance 125 se présente sous la forme d'une nappe 150 d'une épaisseur inférieure à la hauteur capillaire du silicium, d'environ 7 mm. La nappe est maintenue sur le fût sous l'effet de la tension de surface du silicium.

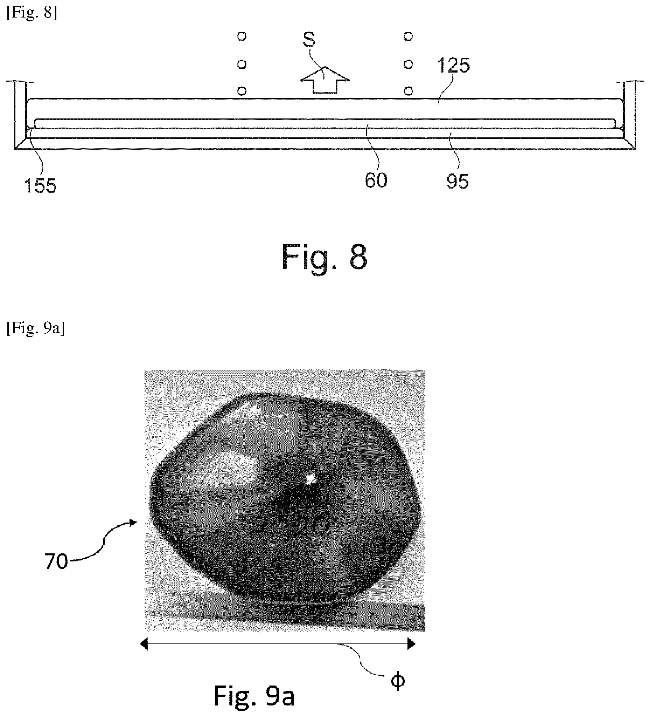

Dans la variante illustrée sur la figure 8, la couche de croissance déborde du fût sur la partie 155 du fond du creuset non recouverte par le fût, et est maintenue par les parois latérales 15 du creuset, l'épaisseur de la couche de surface étant supérieure à la hauteur capillaire. Elle est par exemple de 20 mm. Selon cette variante, le creuset est de préférence recouvert d'une couche antiadhérente de nitrure de silicium, pour faciliter le démoulage du lingot.

### Exemple

Une charge de silicium a été disposée sur le fond d'un creuset en silice recouvert d'un revêtement de nitrure de silicium d'un diamètre de 135 mm.

Le creuset a été disposé dans un four à induction et chauffé au moyen de ce dernier à une température de 1424 °C, de manière à former un bain de silicium d'une hauteur de 100 mm.

Une pièce 70 a ensuite été solidifiée de la façon suivante.

Tout d'abord, un germe de silicium monocristallin d'orientation (100) a été mis en contact avec le bain de silicium.

Dans une première phase, un col 40 a été formé. Tout d'abord, une striction 45 de forme cylindrique a été générée, qui présente un diamètre inférieur au diamètre du germe, en déplaçant le germe en translation, et sans rotation, à une vitesse de translation de 60 mm/h.

La vitesse de translation a ensuite été réduite à 30 mm/h tout en diminuant le gradient horizontal de température, pendant une durée de 1 h, de manière à créer un cône d'élargissement.

Le fût 60 de la pièce a ensuite été formé.

Le lingot a cru à distance des parois latérales du creuset.

Enfin, la pièce a été décollée du bain en augmentant la vitesse de translation du germe à 90 mm/min.

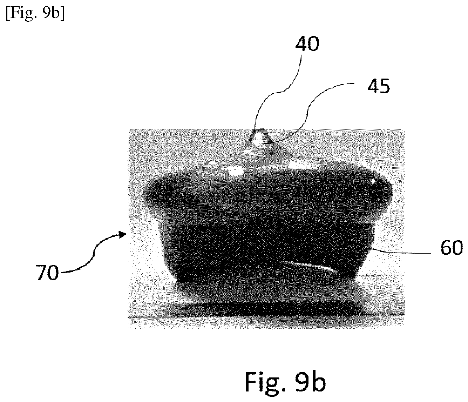

Des photographies de la pièce obtenue sont représentées sur les figures 9a et 9b.

La pièce obtenue présente une excellente qualité cristalline. En particulier, elle est monocristalline et présente un diamètre maximal φ de 120 mm.

Bien évidemment, l'invention n'est pas limitée aux modes de réalisation et de mise en œuvre décrits à titre illustratifs. Par exemple, d'autres applications d'une pièce obtenue par le procédé selon l'invention peuvent être envisagées. Par exemple, la pièce peut être destinée à la production d'un miroir astronomique, ou d'un élément structurel, ou pour la détection des ondes gravitationnelles.

## Revendications

1. Procédé de fabrication d'une pièce (70) comportant un col (40) et un fût (60) prolongeant le col, la pièce comportant une portion monocristalline représentant plus de 80 % de son volume, le procédé comportant les étapes de :
i) fourniture d'un creuset (5) contenant un bain (20) comportant un matériau semi-conducteur en fusion choisi parmi le silicium, le germanium et leurs mélanges, et d'un germe (25) solide comportant le matériau semi-cristallin,
ii) mise en contact du germe avec le bain,
iii) formation du col en translatant le germe par rapport au bain pour extraire et solidifier le matériau semi-conducteur hors du bain, et
iv) formation du fût en refroidissant le bain et en réduisant la vitesse de translation du germe par rapport à l'étape iii),
la pièce présentant au moins une section, transverse à l'axe (X) de translation du germe, dont l'aire est supérieure ou égale à 0,15 m².

2. Procédé selon la revendication 1, la pièce présentant au moins une section, transverse à l'axe (X) de translation du germe, dont l'aire supérieure ou égale à 0,2 m², de préférence supérieure ou égale à 0,5 m², de préférence supérieure ou égale à 0,7 m², par exemple d'environ 1,0 m².

3. Procédé selon l'une quelconque des revendications 1 et 2, l'épaisseur du bain étant inférieure ou égale à 10 cm, de préférence inférieure ou égale à 5 cm.

4. Procédé selon l'une quelconque des revendications précédentes, comportant, au moins durant l'étape ii) et notamment au cours des étapes ii) à iv), le chauffage du bain de telle sorte que le gradient de température entre la surface du bain et le fond du bain, mesuré selon la direction de translation du germe, est inférieur à 3 K/cm.

5. Procédé selon l'une quelconque des revendications précédentes, la mise en contact du germe avec le bain comportant en outre la rotation du germe par rapport au bain, la rotation étant opérée autour de l'axe de translation du germe.

6. Procédé selon l'une quelconque des revendications précédentes, la formation du col comportant la solidification d'une striction (45), en translatant le germe à une vitesse de translation et à une température du bain déterminées pour que le diamètre de la striction (φsₛ) soit inférieur à 10 mm, voire inférieur ou égal à 6 mm, de préférence compris entre 4 mm et 5 mm.

7. Procédé selon la revendication précédente, la formation du col comportant la solidification d'un cône d'élargissement (50) prolongeant la striction le long de l'axe de translation du germe, le cône d'élargissement étant formé par translation du germe à une vitesse inférieure à la vitesse mise en œuvre pour former la striction, le cône d'élargissement ayant un diamètre supérieur au diamètre de la striction.

8. Procédé selon l'une quelconque des revendications précédentes, le refroidissement du bain étant opéré de telle sorte que le gradient de température selon au moins une direction parallèle à la surface du bain, de préférence une direction horizontale, soit inférieur à 3 K/cm, de préférence inférieur à 2 K/cm.

9. Procédé selon l'une quelconque des revendications précédentes, la vitesse de translation du germe au cours de l'étape iv) de formation du fût étant inférieure ou égale à 10 mm/min.

10. Procédé selon l'une quelconque des revendications précédentes, la formation du fût comportant :
- l'élargissement du fût par solidification d'une partie du bain le long de la surface du bain, suivi par
- la croissance axiale du fût le long de l'axe de translation du germe.

11. Procédé selon l'une quelconque des revendications précédentes, comportant postérieurement à l'étape iv) de formation du fût, le décollement de la pièce du bain, la vitesse de translation du germe au cours du décollement étant de préférence supérieure à 5400 mm/h.

12. Procédé selon la revendication précédente, comportant postérieurement au décollement de la pièce, le refroidissement de la pièce.

13. Procédé selon la revendication précédente, au moins l'intégralité du fût, de préférence de la pièce, étant disposée dans le creuset au cours du refroidissement.

14. Procédé selon l'une quelconque des revendications 12 et 13, comportant postérieurement à l'étape de refroidissement, la découpe du fût pour former une plaque (85), et optionnellement l'usinage de la plaque sous une forme générale prismatique, de préférence de forme d'un pavé droit.

15. Procédé selon la revendication précédente, la plaque présentant une longueur (L) et/ou une largeur (1) supérieures à 300 mm, voire supérieures ou égales à 350 mm, voire supérieures ou égales à 400 mm, voire supérieures ou égales à 500 mm, voire supérieures ou égales à 750 mm, voire d'environ 1 m.

16. Procédé selon l'une quelconque des revendications 14 et 15, comportant la mise en place de la plaque au fond d'un creuset et la solidification dirigée, dans le creuset, d'un lingot par initiation de la croissance cristalline sur la plaque.

17. Procédé selon l'une quelconque des revendications 1 à 15, le procédé comportant la fabrication d'un lingot par solidification de couches surfaciques à partir de la pièce, ou le cas échéant de la plaque.

18. Procédé selon la revendication précédente, comportant la solidification d'une base (95) par refroidissement du bain, la fabrication du lingot par solidification de couches surfaciques comportant la mise en contact préalable du fût avec la base.

19. Procédé selon l'une quelconque des revendications 17 et 18, la fabrication du lingot par solidification de couches surfaciques comportant :
a) la fourniture d'une couche de croissance (125) sur la face de la pièce (70) opposée à la base (95), ou le cas échéant sur une face de la plaque (85), la couche de croissance étant formée d'une charge (140) liquide comportant, de préférence pour plus de 80,0 %, de préférence pour plus de 90,0 %, de préférence pour plus de 99,9 % de sa masse le matériau semi-conducteur en fusion,
b) la génération d'un champ de température définissant une zone de solidification (Zs) dans laquelle la température est inférieure à la température de fusion du matériau semi-conducteur, et
c) le déplacement de la base pour disposer une portion (126) de la couche de croissance dans la zone de solidification pour former le lingot et l'alimentation de la couche de croissance hors de la zone de solidification en charge liquide,
la couche de croissance étant alimentée de préférence continûment en charge liquide conjointement au déplacement de la base.

20. Pièce (70), notamment obtenue par le procédé selon l'une quelconque des revendications précédentes, la pièce étant formée pour plus de 99,9 % de sa masse par un matériau semi-conducteur choisi parmi le silicium, le germanium et leurs mélanges, la pièce comportant une portion monocristalline représentant plus de 80 % du volume de la pièce et présentant au moins une section transverse à un axe de la pièce dont l'aire est supérieure ou égale à 0,15 m², de préférence supérieure ou égale à 0,2 m², de préférence supérieure ou égale à 0,5 m², de préférence supérieure ou égale à 0,7 m², par exemple d'environ 1,0 m² la pièce se présentant sous la forme d'une plaque (85).

21. Utilisation d'une pièce selon la revendication précédente pour la solidification, notamment dirigée, d'un lingot de silicium par croissance cristalline initiée sur la pièce
